# EUROPEAN PATENT APPLICATION

(11) **EP 2 679 703 A1**
(43) Date of publication of application: **01.01.2014**
(21) Application number: 12749883.0
(22) Date of filing: 14.02.2012
(51) Int. Cl.: C23C 14/35

(54) **MAGNETRON ELECTRODE FOR PLASMA PROCESSING**

(30) Priority: 25.02.2011 JP 2011039573
(71) Applicant: Toray Industries, Inc., Tokyo, 103-8666 (JP)
(72) Inventor: KAWASHITA, Mamoru, Shiga 5208558 (JP); UEDA, Masanori, Shizuoka 4110824 (JP); EJIRI, Hiroe, Shiga 5208558 (JP); NOMURA, Fumiyasu, Shiga 5208558 (JP)
(74) Representative: Hoefer & Partner
(86) International application number: PCT/JP2012/053401
(87) International publication number: WO 2012/114941

(57) **Abstract**

The invention aims to provide a magnetron electrode for plasma treatment that is free of significant abnormal electrical discharge and able to perform electrical discharge with long-term stability. A second electrode is provided only at a position outside the inner side surface of the outer magnetic pole of a first electrode or at a position where the magnetic flux density is low.

## Description

### Technical field

The present invention relates to a magnetron electrode for plasma treatment.

### Background art

To carry out vacuum thin film formation, there are various film formation methods including deposition, sputtering, and CVD, and an optimum film formation method is selected to meet particular requirements such as the balance between required film characteristics and productivity. In general, sputtering has been often used, particularly when a film of an alloy based material or a large size film with uniform characteristics is to be formed. Compared to other film formation methods, sputtering has the large disadvantage of difficulty in performing film formation at an increased speed and low productivity, and there have been efforts at providing a high speed film formation method such as magnetron sputtering based on the establishment of a technique for increasing the plasma density.

Non-patent document 1 gives an intelligible explanation of the mechanism of magnetron discharge. In simple terms, the technique is designed to increase the plasma density by using a magnetic flux loop to trap electrons. The magnetron sputtering process applies this technique to sputtering electrodes so that high-density plasma works to promote the sputtering mechanism, thereby increasing the film formation speed.

### Prior art documents

### [Non-patent documents]

Non-patent document 1: Non-patent document 1: Plasma Electronics (in Japanese), Hideo Sugai et al., published by Ohmsha, Ltd., October 2000, p.p. 99-101

### Summary of the invention

### Problems to be solved by the invention

As stated in section "Background art", magnetron sputtering is a key technique for increasing the film formation speed, but there remain various problems in practical equipment operations. In particular, abnormal electrical discharge such as arc discharge can cause dust generation and lead to quality defects in workpieces, and accordingly, a variety of efforts have been made aiming to depress abnormal electrical discharge. In performing studies and experiments intended for depressing abnormal electrical discharge, the present inventors found that if a portion with a relatively strong magnetic field intensity in a magnetic circuit of a magnetron plasma electrode contains a member giving an anodic potential, that member will tend to induce abnormal electrical discharge easily. An object of the present invention is to establish a constitution that can depress abnormal electrical discharge to provide a stable magnetron electrode free of significant abnormal electrical discharge.

### Means of solving the problems

To meet the aforementioned object, the present invention provides a magnetron electrode for plasma treatment comprising at least a first electrode having an electrical discharging surface, a magnet to form a magnetic circuit for magnetron on the electrical discharging surface of the first electrode, and a second electrode electrically insulated from the first electrode so as to allow an electric potential to be maintained between the first and the second electrode, wherein the second electrode is disposed so as to hang over the electrical discharging surface of the first electrode with a gap between them extending from the first electrode in the direction perpendicular to its electrical discharging surface, and wherein the inner edge of the second electrode is located outside the inner side surface of the outer magnetic pole of the magnetic circuit and simultaneously inside the outer side surface of the first electrode.

A preferred embodiment of the present invention provides a magnetron electrode for plasma treatment wherein the second electrode is disposed at such a position that at the surface of the second electrode opposite to the first electrode, the magnetic flux density is 20 millitesla or less in the perpendicular direction to the second electrode.

Another embodiment of the present invention provides a magnetron electrode for plasma treatment comprising at least a first electrode having an electrical discharging surface, a magnet to form a magnetic circuit for magnetron on the electrical discharging surface of the first electrode, and a second electrode electrically insulated from the first electrode so as to allow an electric potential to be maintained between it and the first electrode, wherein the second electrode is disposed at such a position that at the surface of the second electrode opposite to the first electrode, the magnetic flux density is 20 millitesla or less for the second electrode and wherein the inner edge of the second electrode is located inside the outer side surface of the first electrode.

A preferred embodiment of the present invention provides a magnetron electrode for plasma treatment further comprising an auxiliary magnet on the inner side surface of the outer magnetic pole in the magnetic circuit.

Another preferred embodiment of the present invention provides a magnetron electrode for plasma treatment configured so that gas is discharged through the gap between the first electrode and the second electrode into a discharging space near the electrical discharging surface of the first electrode.

Still another preferred embodiment of the present invention provides a magnetron electrode for plasma treatment further comprising an insulator that surrounds the first electrode excluding its electrical discharging surface with a gap maintained between the insulator and the first electrode and a chamber that is provided on the portion of the insulator facing the opposite side of the first electrode to the electrical discharging surface to allow gas to be introduced into the chamber and sent through the gap, which acts as gas flow channel, between the first electrode and the insulator connected to the chamber so that the gas is discharged through the gap between the first electrode and the second electrode into the discharging space near the electrical discharging surface of the first electrode.

Furthermore, still another embodiment of the present invention provides a sputtering electrode comprising a magnetron electrode for plasma treatment as described above wherein the first electrode has at least a target and a backing plate, the backing plate being cooled by cooling water, the target being cooled by being in contact with the backing plate, and the target and the backing plate being configured so that they are detachable.

Still another preferred embodiment of the present invention provides a film formation method for forming a thin film on a base by means of a sputtering electrode disposed in a vacuum tank, comprising the use, as the sputtering electrode, of a magnetron sputtering electrode as described above.

### Effect of the invention

The present invention serves to produce a magnetron electrode for plasma treatment that is free of significant abnormal electrical discharges and able to perform electrical discharges with long-term stability. This makes it possible to provide a plasma treatment method, film formation method, and film formation equipment with depressed generation of dust attributable to abnormal electrical discharge and reduced risk of quality deterioration attributable to dust attached on workpieces.

### Brief description of the drawings

[Fig. 1] Fig. 1 shows a schematic cross section of an electrode for DC magnetron sputtering according to the present invention.
[Fig. 2] Fig. 2 shows a schematic plan view of the electrode for DC magnetron sputtering given in Fig. 1, viewed from above the electrical discharging surface.
[Fig. 3a] Fig. 3a shows a schematic cross section of a structure without a cathode case according to another embodiment of the present invention.
[Fig. 3b] Fig. 3b shows a schematic cross section of a structure without an auxiliary magnet according to another embodiment of the present invention.
[Fig. 3c] Fig. 3c shows a schematic constitution of a typical magnetic circuit of another type according to another embodiment of the present invention.

### Description of embodiments

An example of the best mode for carrying out the invention is described below with reference to drawings, taking an electrode for DC magnetron sputtering as an example.

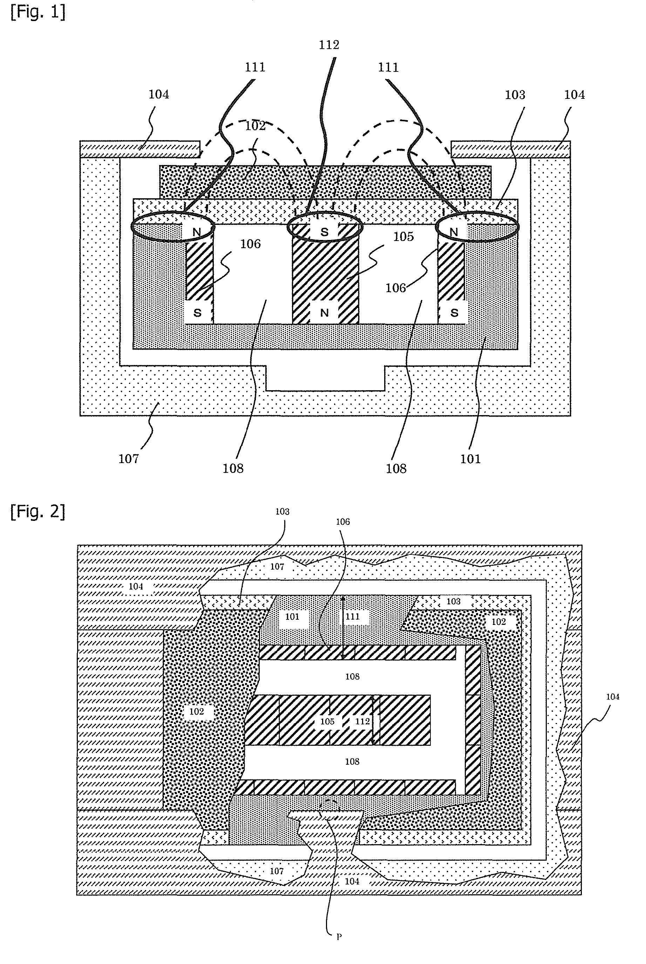

Fig. 1 shows a schematic cross section of an electrode for DC magnetron sputtering according to the present invention. Fig. 2 shows a schematic plan view of the electrode for DC magnetron sputtering given in Fig. 1, viewed from above the electrical discharging surface.

A backing plate 103 is provided to serve as a lid to close the mouth of a cathode case 101, and a target 102 is provided on the backing plate 103. In the widthwise central region of the cathode case 101, main magnets 105, with their south poles facing the target 102, are connected in series and aligned in the length direction of the cathode case, whereas along the inner wall of the cathode case 101, auxiliary magnets 106, with their north poles facing the target 102, are aligned so as to surround the main magnets 105 with a gap maintained between the auxiliary magnets and the main magnet 105. Cooling water is fed to flow through a water pathway 108 to cool the main magnets 105 and the auxiliary magnets 106 and also cool the target 102 via the backing plate 103. This structure has the advantage of being able to serve as a cooling structure to prevent thermal demagnetization of the magnets and simultaneously serve as a cooling structure to cool the target, and it also has the advantage of being able to provide a large cooling area and thereby achieve a high cooling performance. Here, the arrangement involving the polarities of the magnets is not limited to the one shown above as long as the thickness direction of the backing plate 103 coincides the magnetization direction of the magnets and the target-side polarities of the main magnets 105 are not identical to the target-side polarities of the auxiliary magnets 106. Here, the surfaces of the main magnets 105 that face the electrical discharging surface form an inner magnetic pole 112. Outside the cathode case 101, an insulation block 107 is fixed, with a spacer, which is not included in the figure, and a gap provided in between, and an anode 104 is disposed at its end. In a vacuum chamber, a voltage is applied between the anode 104 and the cathode case 101 under an appropriate gas pressure to form a magnetic circuit for magnetron on the electrical discharging surface of the target 102, thereby constructing a high-efficiency sputtering apparatus that generates plasma with its density increased by the magnetron effect. Here, the cathode case 101, target 102, and backing plate 103 are connected electrically and therefore have the same cathodic potential in an electrode having a constitution as shown in Fig. 1 or Fig. 2, and they correspond to the first electrode mentioned in claims. The anode 104 corresponds to the second electrode.

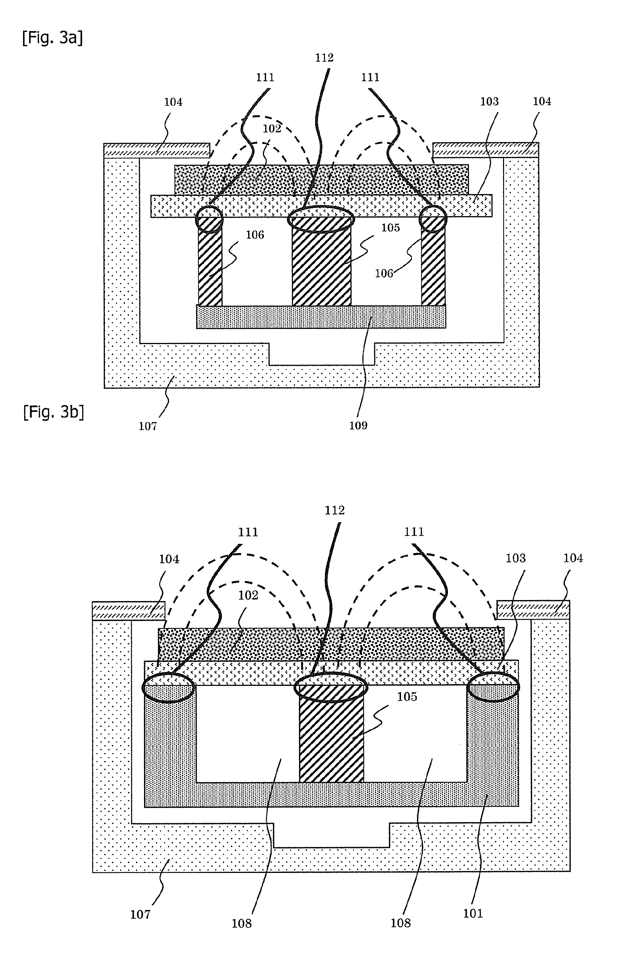

In the cross section give in Fig. 1, the magnetic circuit for magnetron is composed of the main magnets 105 and the auxiliary magnets 106, and the cathode case 101 may be of either a magnetic material or a nonmagnetic material. If the cathode case 101 is of a magnetic material, its yoking will close the magnetic circuit, and the magnetic flux on the target 102 can be increased efficiently. In this case, an outer magnetic pole 111 consists of the surface of the outer wall of the cathode case 101 that faces the electrical discharging surface and the surfaces of the auxiliary magnets 106 that face the electrical discharging surface. Preferred materials for the cathode case 101 include, for instance, carbon steel and ferritic and martensitic stainless steels as well as magnetic metals such as iron and nickel, of which ferritic and martensitic stainless steels are particularly preferable as corrosion resistant magnetic materials. Fig. 3a shows a schematic cross section of an example structure that does not contain a cathode case 101. As shown here, the structure may contain a yoke 109 to close the magnetic flux on the opposite side to the target 102. In this case, the structure may not contain a cathode case 101, and if the structure contains a cathode case 101, it may not be of a magnetic material but of a nonmagnetic material. In this case, the outer magnetic pole 111 consists of the surfaces of the auxiliary magnets 106 that face the electrical discharging surface.

In some cases, a magnetron free of auxiliary magnets 106 can be constructed by forming a magnetic circuit using a cathode case that works as a yoke, thereby serving for cost reduction due to a decrease in the number of components. Fig. 3b gives a schematic cross section of an example structure that does not contain an auxiliary magnet 106. In this case, the outer magnetic pole 111 consists of the surface of the outer wall of the cathode case 101 that faces the electrical discharging surface.

The preferred magnets to be used as the main magnets 105 include, for instance, permanent magnets such as samarium cobalt magnet, neodymium magnet, and ferrite magnet. The main magnets 105 are often required to have a large residual magnetic flux density. The use of a neodymium magnet, which is low in price, may be preferred in such cases, but its magnetic performance is largely dependent on temperature, and therefore, the use of a samarium cobalt magnet, which is high in price, is preferred when used in a thermally rigorous environment.

For the auxiliary magnets 106 as well, the preferred magnets include, for instance, permanent magnets such as samarium cobalt magnet, neodymium magnet, and ferrite magnet. In a structure in which the cathode case 101 serves as a yoke, however, the role of the auxiliary magnets 106 is to absorb part of the magnetic flux emanating from the main magnets, thereby preventing it from forming a wide curving pattern to get behind them. Accordingly, a high residual magnetic flux density is not necessary in many cases. Therefore, it is preferable to use ferrite magnets, which are low in residual magnetic flux density but low in price and also relatively small in temperature dependence of magnet performance.

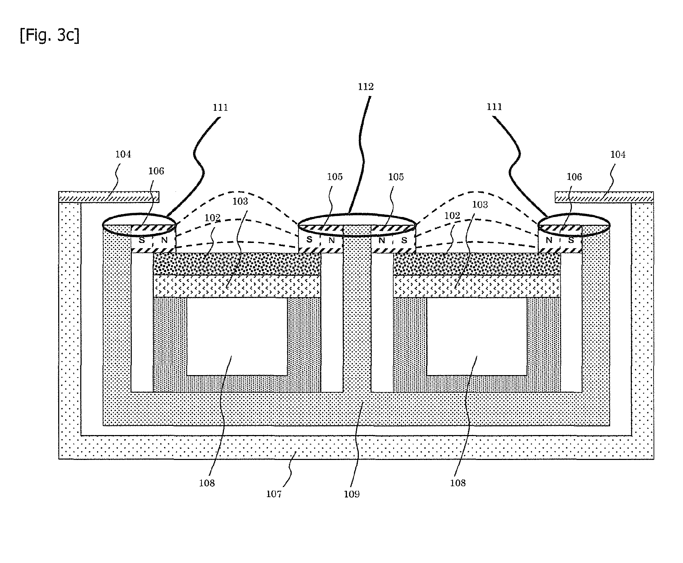

Fig. 3c shows a schematic configuration diagram of another example of a magnetic circuit structure. All structures described above have magnets disposed on the opposite side of the target 102 to the electrical discharging surface so as to form a magnetic circuit on the electrical discharging surface side of the target 102, but a magnetic circuit can also be formed by disposing magnets on the electrical discharging surface side of a target 102 as illustrated in Fig. 3c. The arrangement involving the polarities of the magnets is not limited to the one shown in the example as long as the arrays of magnets facing each other are not disposed in repelling directions.

The material to be used for the target 102 may be selected accordingly depending on the required characteristics of the film to be produced. When a metal material is used, it will be connected to the backing plate 103 and the cathode case 101 and will have the same electric potential.

The backing plate 103 functions to perform heat exchange to allow the plasma heat, Joule heat, and sputtering heat received by the target 102 to be released into the cooling water flowing through the water pathway 108 and also functions to maintain electric connection with the cathode case 101 to share the same electric potential. Accordingly, it is preferably made of copper, aluminum, or an alloy thereof which are high in both heat conductivity and electric conductivity. The use of a copper alloy is preferable because the member is likely to suffer from corrosion because electricity is applied to it while it is in contact with cooling water and dissimilar metals. The backing plate 103 also works as a lid for the cathode case 101 to form the water pathway 107 when assembled. The cooling water passing through the water pathway 107 serves for direct cooling of the large surface of the backing plate 103, accordingly leading to a high cooling performance. If a target 102 is put on and brought into contact with the opposite surface of the backing plate 103 to the water pathway 107, the heat of the target 102 will be released into the cooling water via the backing plate 103. Here, the target 102 may be bonded to the backing plate 103, but in that case, both the target and the backing plate will have to be replaced together when the target has been used up, and therefore, it is preferable for the target to be assembled with the backing plate in a detachable manner to allow the target to be replaced separately. Furthermore, the fastener member for fixing the backing plate 103 to the cathode case 101 may be provided separately from the fastener member for maintaining the target 102 in contact with the backing plate 103 so that the backing plate 103 and the cathode case 101 can be maintained in an assembled state even after detaching the target 102 from the backing plate 103. This structure is more preferable because it is not necessary to discharge the cooling water from the cathode case 101 when replacing the target, thus permitting efficient target replacement.

The insulation block 107 functions to achieve electric insulation between the anode 104 and the cathode case 101 and also functions to form a gap to the cathode case 101. This gap serves as a gas flow channel used for electrical discharge, allowing gas to be supplied uniformly across the width from between the anode 104 and the target 102 into the discharging space. Another available method is direct supply through a gas nozzle from a neighborhood of the discharging space, but this relatively tends to cause uneven gas supply depending on the shape of the gas nozzle. Compared to this, the method according to the present invention is favorable because it can reduce the unevenness in gas supply. In addition, the use of a chamber disposed in the gas flow channel is more preferable because the unevenness in gas supply can be further reduced. Any insulator may be used as material for the insulation block 107, but ceramics and the like are expensive, heavy, brittle, and liable to cracking, and more preferable are various resins including so-called general purpose resins such as polyvinyl chloride and nylon and other general purpose engineering plastics such as ultrahigh molecular weight polyethylene and polyacetal. In particular, relatively heat resistant materials called super engineering plastics such as polyimide, polyphenylene sulfide, polyether ether ketone, and polytetrafluoroethylene are more preferable as materials for use near a heat source such as plasma.

The anode 104 is provided so as to hang over the periphery of the backing plate 103 or the target 102 when viewed from above the electrical discharging surface, while an opening is provided in the central region so as not to prevent the flight of sputtered particles. Thus, it works as a counter electrode to apply a voltage between it and the backing plate 103 or the target 102. To achieve this, the target 102 and the anode 104 are required to be electrically insulated from each other, and therefore, they are disposed with a gap provided in between. An arrangement in which, when viewed from above the electrical discharging surface, the anode 104 is located further outside the target 102 so that the periphery of the target 102 is visible is not preferable because dust, if attached to a member located in the gap between the anode 104 and the target 102, will cause abnormal electrical discharge. Therefore, it is preferable for the gap to be disposed in the direction perpendicular to the electrical discharging surface. If the gap is too large, sputtered particles are trapped on the surface of the anode 104 that faces the target 102 to easily cause abnormal electrical discharge, whereas if it is too small, dust entering there will cause abnormal electrical discharge. Experimental data obtained by the present inventors show that the size of the gap from the surface of the target 102 to the surface of the anode 104 that faces the target 102 is preferably in the range of 1 mm to 7 mm. An appropriate one may be selected from a variety of metal materials from the viewpoint of electric characteristics and material characteristics, but the use of copper or a copper alloy is preferable because of their high heat conductivity and electric conductivity. It is preferable to provide a cooling structure because these members are exposed to plasma heat and Joule heat.

In view of electric power loss, rectification effect of gas, and efficient gas supply into the discharging space, it is naturally preferable that the opening surrounded by the anode 104 be so small as to expose only the erosion region of the target 102, but for the present invention, it was found by the inventors that abnormal electrical discharge can be induced easily by a member having an anodic potential if the member is located at a position with a relatively strong magnetic field intensity in the magnetic circuit of a magnetron plasma electrode. It was also found that if the opening-side edge of the anode 104 is located outside the outer side surface of the cathode, the side surface of the cathode will be contaminated with sputtering residues and the like in the course of long-term discharge to induce abnormal electrical discharge.

To depress such abnormal electrical discharge, it is preferable for the opening-side edge of the anode to be located outside the inner side surface of the outer magnetic pole and simultaneously inside the outer side surface of the cathode, i.e., inside the surface of the cathode case 101, backing plate 102, or target 103, whichever is outmost, and furthermore, it is more preferable that the magnetic flux density in the direction perpendicular to the anode be 20 millitesla or less. A magnetic flux density in the direction perpendicular to the anode of 20 millitesla or less is preferable because an equivalent level of abnormal electrical discharge depression effect can be realized by disposing the opening-side edge of the anode at a position inside the outer side surface of the cathode.

### Examples

### [Example 1]

Some magnetron sputtering electrodes according to the present invention that differ in magnetic circuit constitution for magnetron, magnetic field intensity, or anode opening size were prepared and subjected to tests for abnormal electrical discharge, and their comparison is described in Examples, whereas results of the same tests of magnetron sputtering electrodes that are not according to the present invention are described in Comparative examples.

Their structures are first explained in detail in text, and subsequently differences among the structures and differences in the degree of abnormal electrical discharge are shown in tables.

Described first is an electrode corresponding to claim 1, which has a cross section as shown in Fig. 3b. The cathode case was produced using SUS430 ferritic stainless steel. The recess in the cathode case had the following inside dimensions: a width of 82 mm, length of 272 mm, and depth of 20 mm. The cathode case had the following outside dimensions: width of 108 mm, length of 298 mm, and height of 24.5 mm. Thus, the outer magnetic pole had a width of 13 mm. In the central portion of the recess of a cathode case, an array of neodymium magnets (Grade: N40) supplied by NeoMag Co., Ltd., each having a length of 40 mm, width of 10 mm, and height of 20 mm and magnetized in the height direction to serve as a main magnet, was disposed along the length direction in such a manner that the south pole points toward the mouth of the cathode case, and no auxiliary magnet was used. The neodymium magnets had a surface magnetic flux density of 520 millitesla. A backing plate was fixed so as to close the recess in the cathode case and sealed with an 0-ring. The backing plate was made of C1020 oxygen free copper and had a width of 108 mm, length of 298 mm, and thickness of 3 mm. The fixing of the backing plate to the cathode case was achieved by using countersunk head screws and their screw heads were driven into the backing plate. A target was put on the surface of the backing plate, and target clamps were used to press the target against the backing plate. The target was made of C1020 oxygen free copper and had a width of 82 mm, length of 290 mm, and thickness of 8 mm. Two target clamps of SUS304 austenitic stainless steel, each having a width of 13 mm, length of 290 mm, and thickness of 8 mm, were used. They were hooked to the two long sides of the target and screwed to the cathode case so as to press the target against the backing plate. If the screw heads protruded, they would cause electric field concentration. Therefore, countersunk head screws were used, and their heads were driven into the target clamps. An anode was attached with a gap of 4 mm from the surface of the target. The anode was made of C1020 oxygen free copper and had a width of 158 mm, length of 348 mm, and thickness of 3 mm. The mouth had a width of 98 mm and length of 289 mm as measured through the center. Specifically, the inner edge of the anode was located 8 mm outside the inner side surface of the outer magnetic pole and 5 mm inside the outer side surface of the outer magnetic pole, i.e., the outer side surface of the cathode.

For magnetron sputtering electrodes as constructed above, the magnetic flux density in the direction perpendicular to the anode was measured at the inner edge of the anode. A TM-201 gaussmeter supplied by Kanetsu Kogyo Co., Ltd. was used for the measurement, which was performed by bringing the measuring element at the end of the probe into direct contact with the opening-side edge of the anode at its lengthwise center (the point denoted by P in Fig. 2). Measurements were made as described above for Examples 1, 2, and 3 and Comparative example , and results are shown in Table 1 along with the distance from the inner side surface of the outer magnetic pole of the cathode to the inner edge of the anode.

Described below are the conditions for the electrical discharge test. For the electrical discharge test, a magnetron sputtering electrode was placed in a vacuum chamber, and a RPG-100 pulsed dc generator supplied by ENI was connected. Regarding the vacuum conditions, the chamber was first vacuated to below 2.0×10⁻² Pa, and then the pressure was adjusted to 1.0 Pa by controlling a pressure control valve. The pulse oscillation conditions of the generator included a frequency of 250 kHz and inversion time of 1.6 µsec, and the output power was 4 kW. Oxygen was used as sputtering gas and supplied at a flow rate of 200 sccm from between and the anode and the cathode of the electrode into the discharging space on the target surface.

Under the above electrical discharge conditions used in common, electrodes configured for Examples 1, 2, and 3 and Comparative examples were subjected to electrical discharge test. Table 1 compares the resulting abnormal electrical discharge. The degree of the resulting abnormal electrical discharge is denoted by "×" for cases where the degree of abnormal electrical discharge was so high as to cause disappearance of plasma, "○" for cases where small arc discharge occurs occasionally, but plasma discharge can be maintained, and "⊚" for cases where abnormal electrical discharge, including small arc discharge, occurs scarcely. The degree of abnormal electrical discharge generation observed 3 hours after the start of electrical discharge is also shown in Table 1.

### [Example 2]

The electrode tested was the same as that in Example 1 except for having an altered magnetic circuit. Specifically, at the widthwise center of the cathode case, instead of an array of neodymium magnets each having a length of 40 mm, width of 10 mm, and height of 20 mm and magnetized in the height direction, neodymium magnets (Grade: N35) supplied by NeoMag Co., Ltd., each having a length of 50 mm, width of 10 mm, and height of 10 mm and magnetized in the height direction were aligned in the length direction in such a manner that the south pole points toward the mouth of the cathode case, and no auxiliary magnet was used. The neodymium magnets had a surface magnetic flux density of 390 millitesla. The electrode constitution was the same in other respects as that in Example 1. Test results are also shown in Table 1. The degree of abnormal electrical discharge generation observed 3 hours after the start of electrical discharge is also shown in Table 1.

### [Example 3]

The electrode tested was the same as that in Example 1 except for having a cross-sectional electrode structure as illustrated in Fig. 1. Specifically, the same main magnets were placed at the widthwise center of the cathode case, whereas as auxiliary magnets, anisotropic ferrite magnets supplied by Sagami Chemical Metal Co., Ltd. having a length of 65 mm, width of 4 mm, and height of 19 mm were disposed along the inner surface of the outer magnetic pole of the cathode case in such a manner that the north pole pointed to the mouth of the cathode case. These anisotropic ferrite magnets had a surface magnetic flux density of 140 millitesla. The electrode constitution was the same in other respects as that in Example 1. Test results are also shown in Table 1. The degree of abnormal electrical discharge generation observed 3 hours after the start of electrical discharge is also shown in Table 1.

### [Comparative example 1]

The electrode tested was the same as that in Example 1 except for having an anode opening with an altered size. Specifically, the anode opening had a width of 80 mm and length of 271 mm as measured through the center. Consequently, it is located 1 mm inside the inner side surface of the outer magnetic pole of the cathode, and accordingly, it is outside the range claimed in the present invention. The electrode constitution was the same in other respects as that in Example 1. Test results are also shown in Table 1. Here, the electrode suffered from frequent abnormal electrical discharge, and was not subjected to electrical discharge test 3 hours after the start of electrical discharge.

### [Comparative example 2]

The electrode tested was the same as that in Example 1 except for having an anode opening with an altered size. Specifically, the anode opening had a width of 111 mm and length of 301 mm as measured through the center. Thus, the edge of the anode is located outside the outer side surface of the cathode, and accordingly outside, though slightly, the range claimed in the present invention. The electrode constitution was the same in other respects as that in Example 1.

When subjected to electrical discharge test, this electrode showed high electrical discharge performance in the initial stage of electrical discharge, comparing favorably with the electrode prepared for Example 1, but the side surface of the cathode was found to be contaminated 3 hours after the start of electrical discharge, leading to frequent abnormal electrical discharge on the side surface of the cathode. This phenomenon was not encountered in Examples 1, 2, and 3.

**[Table 1]**

| | Distance from inner side surface of cathode to inner edge of anode [mm] | Magnetic flux density at inner edge of anode [mT] | Power source [kW] | Voltage [V] | Current [A] | Degree of arc discharge (initial) | Degree of arc discharge (after 3 hours) |
|---|---|---|---|---|---|---|---|
| Example 1 | 8 | 18 | 4 | 323.3 | 12.37 | ○ | ○ |
| Example 2 | 8 | 14 | 4 | 323.6 | 12.37 | ○ | ○ |
| Example 3 | 8 | 17 | 4 | 317.7 | 12.58 | ⊚ | ⊚ |
| Comparative example 1 | -1 | 21 | 4 | 338.5 | 11.81 | × | - |
| Comparative example 2 | 14.5 (outside the edge of cathode) | - | 4 | 332.5 | 12.11 | ○ | × |

### [Industrial applicability]

Here, the present invention is described in detail with reference to DC magnetron sputtering electrodes as examples. However, the invention is not limited thereto, and can be applied to other various electrodes including, but not limited to, those for RF sputtering, surface modification with plasma, and plasma CVD.

### Explanation of numerals

- 101:: cathode case
- 102:: target
- 103:: backing plate
- 104:: anode
- 105:: main magnet
- 106:: auxiliary magnet
- 107:: insulation block
- 108:: water pathway
- 109:: yoke
- 111:: outer magnetic pole
- 112:: inner magnetic pole
- P:: perpendicular magnetic flux density measuring point

## Claims

1. A magnetron electrode for plasma treatment comprising at least a first electrode having an electrical discharging surface, a magnet to form a magnetic circuit for magnetron on the electrical discharging surface of the first electrode, and a second electrode electrically insulated from the first electrode so as to allow an electric potential to be maintained between the first and the second electrode, wherein the second electrode is disposed so as to hang over the electrical discharging surface of the first electrode with a gap between them extending from the first electrode in the direction perpendicular to its electrical discharging surface, and wherein the inner edge of the second electrode is located outside the inner side surface of the outer magnetic pole of the magnetic circuit and simultaneously inside the outer side surface of the first electrode.

2. A magnetron electrode for plasma treatment of claim 1, wherein the second electrode is disposed at such a position that at the surface of the second electrode opposite to the first electrode, the magnetic flux density in the perpendicular direction to the second electrode is 20 millitesla or less.

3. A magnetron electrode for plasma treatment comprising at least a first electrode having an electrical discharging surface, a magnet to form a magnetic circuit for magnetron on the electrical discharging surface of the first electrode, and a second electrode electrically insulated from the first electrode so as to allow an electric potential to be maintained between the first and the second electrode, wherein the second electrode is disposed at such a position that at the surface of the second electrode opposite to the first electrode, the magnetic flux density is 20 millitesla or less for the second electrode and wherein the inner edge of the second electrode is located inside the outer side surface of the first electrode.

4. A magnetron electrode for plasma treatment of any one of claims 1 to 3, wherein an auxiliary magnet is disposed on the inner side surface of the outer magnetic pole of the magnetic circuit.

5. A magnetron electrode for plasma treatment of any one of claims 1 to 4 configured so that gas is discharged through a gap between the first electrode and the second electrode into a discharging space near the electrical discharging surface of the first electrode.

6. A magnetron electrode for plasma treatment of claim 5 further comprising an insulator that surrounds the first electrode excluding its electrical discharging surface with a gap maintained between the insulator and the first electrode and a chamber that is provided on the portion of the insulator facing the opposite side of the first electrode to the electrical discharging surface to allow gas to be introduced into the chamber and sent through the gap, which acts as gas flow channel, between the first electrode and the insulator connected to the chamber so that the gas is discharged through the gap between the first electrode and the second electrode into a discharging space near the electrical discharging surface of the first electrode.

7. A magnetron sputtering electrode comprising a magnetron electrode for plasma treatment of any one of claims 1 to 6, wherein the first electrode has at least a target and a backing plate, the backing plate being cooled by cooling water, the target being cooled by being in contact with the backing plate, and the target and the backing plate being configured so that they are detachable.

8. A film formation method for forming a thin film on a base by means of a sputtering electrode disposed in a vacuum tank, comprising the use, as the sputtering electrode, of a magnetron sputtering electrode of claim 7.
